# FASCICULE DE BREVET EUROPEEN

(11) **EP 0 409 746 B1**
(45) Date de publication et mention de la délivrance du brevet: **28.05.1997**
(21) Numéro de dépôt: 90420329.6
(22) Date de dépôt: 11.07.1990
(51) Int. Cl.: H01L 27/088, H01L 27/02, H01L 27/06, H01L 29/772, H01L 21/82

(54) **Circuit intégré VDMOS/logique comprenant un transistor vertical déplété et une diode zener**
Integrierter VDMOS/Logikschaltkreis mit vertikalem Transistor vom Verarmungstyp und einer Zenerdiode
Integrated VDMOS/logic circuit comprising a vertical depletion transistor and a zener diode

(30) Priorité: 17.07.1989 FR 8909911
(43) Date de publication de la demande: 23.01.1991
(73) Titulaire: SGS-THOMSON MICROELECTRONICS S.A., 94250 Gentilly (FR)
(72) Inventeur: Bancal, Bernard, F-13100 Aix en Provence (FR)
(74) Mandataire: de Beaumont, Michel

(56) Documents cités:
- EP-A- 0 059 878
- EP-A- 0 294 888
- EP-A- 0 319 047
- US-A- 4 163 988

## Description

La présente invention concerne le domaine des circuits intégrés de puissance incluant une partie logique sur la même puce. Elle concerne plus particulièrement des structures de type transistor VDMOS dans lesquelles sont également réalisés des circuits logiques à transistors MOS à canal N de type latéral enrichis et déplétés.

On va tout d'abord rappeler la structure de circuit intégré considérée qui est déjà décrite par exemple dans la demande de brevet européen EP-A-0 236 200 au nom de Thomson CSF.

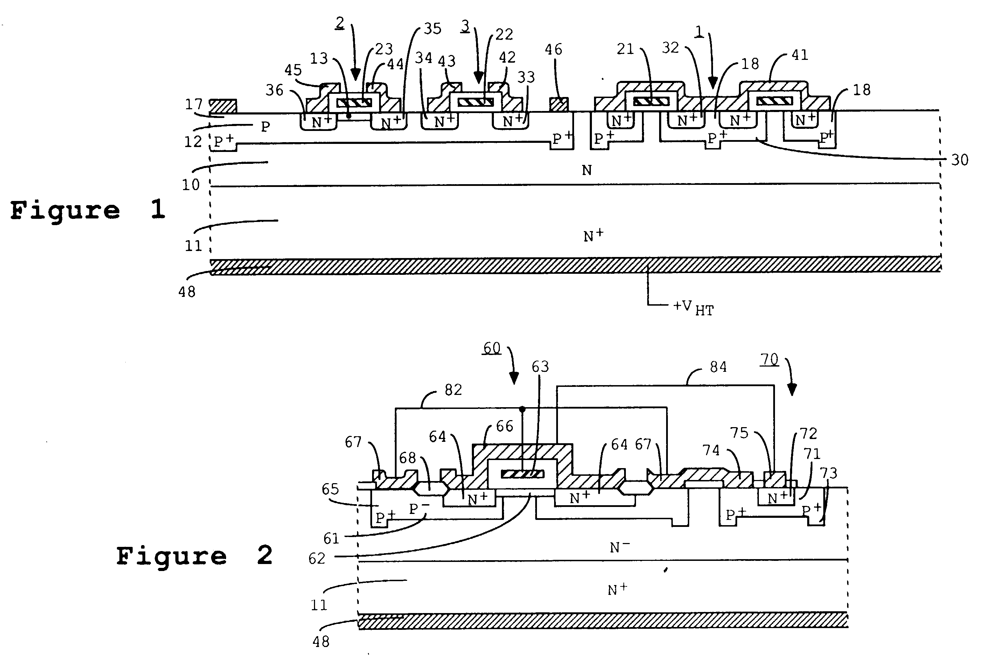

La figure 1 est une vue en coupe fortement schématique d'une telle structure. Seuls certains éléments de cette structure sont représentés par souci de simplification (en particulier certaines couches d'oxyde mince et épais ne sont pas représentées). La partie droite de la figure illustre une structure de puissance 1 de type transistor VDMOS (transistor MOS vertical à canal diffusé) à enrichissement et la partie gauche de la figure représente des composants logiques tels qu'un transistor MOS latéral à canal N déplété 2 et un transistor MOS latéral à canal N enrichi 3.

Cette structure est réalisée sur un substrat comprenant une couche 10 de type N formée par épitaxie sur une plaquette de silicium 11 de type N⁺.

Dans une première étape de dopage, on forme des régions 12 de type P correspondant notamment à des caissons dans lesquels sera élaborée la partie logique de la puce.

Dans une deuxième étape de dopage, on forme des régions P⁺ à niveau de dopage élevé, suffisamment élevé pour obtenir un contact ohmique avec des métallisations. Ces régions P⁺ sont par exemple des régions 17 permettant de prendre un contact ohmique avec le caisson 12 et des régions 18 du transistor de puissance permettant de prendre un contact avec la région dite de "bulk" dans une partie superficielle de laquelle se forme le canal.

Dans une troisième étape de dopage, on forme des régions 13 de type N correspondant notamment aux régions de canal des transistors MOS latéraux déplétés.

Ensuite, on forme de façon classique (par exemple par oxydation, dépôt de silicium polycristallin, gravure et réoxydation) les grilles 21 du transistor VDMOS enrichi, 22 des transistors MOS latéraux enrichis, et 23 des transistors MOS latéraux déplétés (ces grilles sont formées simultanément).

Une quatrième étape de dopage de type P dans la région des cellules de transistor vertical de puissance sert à former les régions de canal 30 de ces transistors, les régions de grille servant de masque.

Après cela, dans une cinquième étape de dopage, on forme, en utilisant encore notamment les grilles susmentionnées comme masque, des régions N⁺ correspondant notamment aux sources 32 du transistor de puissance 1 et aux sources et drains 33 à 36 des transistors MOS latéraux déplétés et enrichis 2 et 3.

Enfin, après oxydation et ouverture des fenêtres appropriées, on forme une couche de métallisation dans laquelle on découpe la métallisation de source 41 du transistor de puissance, et les métallisations de source et de drain 42 à 45 des transistors latéraux ainsi que d'autres métallisations telles que des métallisations 46 de contact des caissons dans lesquels sont formés les composants logiques.

D'autre part, la face arrière du composant qui correspond au drain du transistor VDMOS est recouverte d'une métallisation 48.

En fonctionnement, une telle structure est généralement connectée de sorte que sa face arrière 48 est au potentiel le plus positif (+V_{HT}), toutes les autres métallisations (sauf dans certains montages la métallisation de grille du transistor de puissance) étant à des potentiels inférieurs et la métallisation 46 du caisson 12 étant couramment connectée à la masse.

La structure ci-dessus décrite est particulièrement attrayante par sa simplicité. En effet, elle nécessite un nombre minimal d'étapes de masquage et de dopage. Comme on l'a vu précédemment, seulement cinq types de dopage sont prévus.

Toutefois, cette simplicité entraîne que le nombre de composants réalisables dans une telle structure est limité.

Or, les utilisateurs aimeraient, tout en conservant les avantages de faible prix et de fiabilité qui y sont associés, disposer de composants élémentaires supplémentaires pour pouvoir intégrer diverses fonctions sur une même puce.

En particulier, il est souvent souhaitable de disposer d'une référence de tension issue de la tension de face arrière V_{HT} permettant par exemple de commander la grille du transistor VDMOS enrichi. Ce problème a déjà été traité par exemple dans le brevet américain 4 792 840 délivré le 20 décembre 1988 à Bruno Nadd et cédé à Thomson-CSF. On notera qu'à l'époque du dépôt de ce brevet on considérait comme pratiquement irréalisable de former une diode zener dans une structure du type de celle précédemment décrite. En effet on peut lire : "Clipping by means of the Zener diode is difficult to obtain because of the difficulty of integrating this element" (colonne 2, lignes 33 à 35) soit en français "un écrétage par diode zener est difficilement envisageable à cause de la difficulté que présente cet élément à l'intégration".

Pour résoudre ce problème, ce brevet antérieur propose de ramener la haute tension apparaissant sur la face inférieure du composant vers la face supérieure par l'intermédiaire d'une diffusion N⁺ puis de répartir cette haute tension par une résistance spirale.

Cette solution donne des résultats satisfaisants mais présente l'inconvénient de nécessiter une surface importante de silicium de la puce. En outre, comme on vient de le mentionner, ce procédé ne permet pas d'obtenir de façon interne au composant une tension de référence, mais seulement une tension divisée par l'intermédiaire d'un pont résistif.

Ainsi, un objet de la présente invention est de prévoir, dans un circuit intégré réalisé selon la technologie exposée précédemment, et sans augmenter le nombre d'étapes de fabrication, des moyens pour ramener vers la face supérieure la haute tension disponible sur la face inférieure.

Un autre objet de la présente invention est de fournir à partir de la haute tension disponible sur la face inférieure une tension de référence.

Un autre objet de la présente invention est de permettre l'obtention d'une telle tension de référence sans entraîner une consommation importante du circuit intégré.

Pour atteindre ces objets, la présente invention prévoit d'abord de réaliser dans une structure de type de celle décrite précédemment, un composant supplémentaire à savoir un transistor MOS vertical déplété.

Un procédé de fabrication d'un circuit intégré selon l'invention est défini par les termes de la revendication 1.

Un circuit selon l'invention est défini par les termes de la revendication 5.

En outre, la présente invention prévoit de former une diode zener comprenant une région N⁺ résultant de la cinquième étape de dopage formée dans une région P résultant de la quatrième étape de dopage.

Selon un avantage de l'invention, en utilisant pour le transistor VDMOS déplété et la diode zener les étapes de dopage indiquées précédemment, on obtient une diode zener dont la tension de déclenchement est voisine de la tension de seuil du transistor MOS déplété. Ainsi, ce transistor fonctionne au voisinage de sa zone de blocage et est donc relativement résistif ce qui limite la consommation de courant du circuit.

Ces objets, caractéristiques et avantages de la présente invention seront exposés plus en détail dans la description suivante d'un mode de réalisation particulier faite en relation avec les figures jointes parmi lesquelles :
la figure 1, destinée à exposer l'état de la technique a été décrite précédemment ;
La figure 2 est une vue en coupe d'une partie d'une puce de circuit intégré dans laquelle on a réalisé des composants selon la présente invention ;
les figures 3 et 4 représentent des modes de connexion classiques d'un transistor de puissance à enrichissement et d'une charge ; et
la figure 5 illustre une application de la présente invention.

Dans ces diverses figures, on notera que les dimensions latérales et les épaisseurs des diverses couches ne sont pas tracées à l'échelle conformément à l'usage dans le domaine de la représentation des circuits intégrés mais que ces diverses couches ou portions de couches sont arbitrairement dilatées pour améliorer la lisibilité des figures.

La figure 2 représente une vue en coupe partielle d'un composant selon la présente invention formé dans une structure du type de celle de la figure 1. Cette figure représente plus particulièrement dans sa partie gauche un transistor VDMOS (transistor MOS vertical diffusé) déplété 60 et dans sa partie droite une diode zener 70.

Le transistor VDMOS déplété est réalisé en formant son caisson 61 de type P⁻ lors de la première étape de dopage, en même temps que l'on forme le caisson 12 des circuits logiques. Lors de la troisième étape de dopage, tandis que l'on forme la couche N⁻ de canal des transistors logiques déplétés, on forme simultanément une couche N⁻ 62 qui correspondra à la région de canal déplété du transistor 60. Après cela, on forme de façon classique une grille isolée 63 (cette grille isolée 63 est représentée comme décentrée par rapport au caisson 61, en effet, il n'y a pas d'étapes d'autoalignement entre la formation du caisson et la formation de la grille, mais ceci est sans importance pratique puisque le canal se forme dans la région 62 et non pas dans la région 61). Après cela, on réalise les diffusions de source 64 de type N⁺ lors de la cinquième étape de dopage. Des régions 65 de type P⁺ réalisées lors de la deuxième étape de dopage permettent de prendre des contacts avec le caisson. La référence 66 désigne une métallisation de source et la référence 67 une métallisation de caisson (bulk). On notera que ces métallisations sont éventuellement séparées par une zone d'oxyde épais 68. Le drain de ce transistor VDMOS déplété est commun avec celui du transistor VDMOS enrichi 1 et correspond à la métallisation 48.

La partie droite de la figure représente une diode zener obtenue par une diffusion 71 de type P résultant de la quatrième étape de dopage dans laquelle est formée une région 72 de type N⁺ résultant de la cinquième étape de dopage. Ainsi, la région de type P 71 a un niveau de dopage qui correspond à celui des caissons 30 du transistor VDMOS enrichi de la figure 1. Cette diode est classiquement entourée d'un anneau 73 de type P⁺ correspondant à la deuxième étape de dopage et sur lequel est formée une métallisation d'anode 74, une métallisation de cathode 75 étant formée sur la région N⁺ 72.

Ainsi, la présente invention permet de former un transistor VDMOS déplété et une diode zener sans ajouter une seule étape au processus technologique classique de fabrication d'une structure à transistor de puissance VDMOS enrichi et à transistors logiques de type MOS latéral enrichis et déplétés.

En outre, avec les niveaux de dopage habituellement utilisés dans les structures telles que celles de la figure 1, à savoir :
région P⁻ résultant de la première étape de dopage :
   quelques 10¹⁶ atomes/cm³,
région P résultant de la deuxième étape de dopage :
   quelques 10¹⁷ atomes/cm³,
région N résultant de la troisième étape de dopage :
   quelques 10¹⁶ atomes/cm³,
région P⁺ résultant de la quatrième étape de dopage :
   quelques 10¹⁸ atomes/cm³
région N⁺ résultant de la cinquième étape de dopage :
   quelques 10²⁰ atomes/cm³,
on obtient pour le transistor VDMOS déplété décrit ci-dessus une tension de seuil (c'est-à-dire une tension nécessaire à son blocage) de l'ordre de 10 volts et pour la diode zener formée entre la région N⁺ et la couche P résultant de la quatrième étape de dopage une tension zener qui est également de l'ordre de la dizaine de volts.

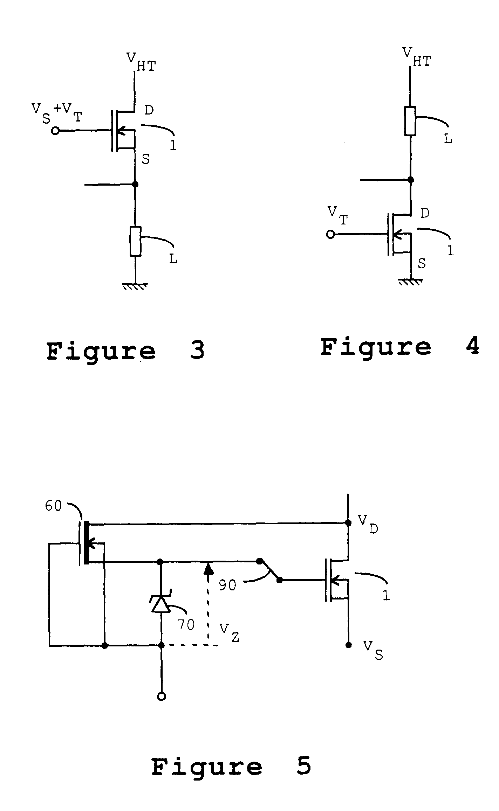

Les figures 3 et 4 représentent les deux modes habituels de montage d'une charge L en série avec in interrupteur constitué d'un transistor VDMOS enrichi à canal N.

La figure 3 représente un montage classiquement désigné par l'appellation "high side", c'est-à-dire un montage dans lequel une charge L est connectée à la masse et le drain du transistor VDMOS 1 à la haute tension. La figure 4 représente un montage dit "low side" dans lequel la charge L est connectée à la haute tension et la source du transistor VDMOS 1 à la masse. Dans ces deux types de montage, pour rendre le transistor VDMOS conducteur, il faut mettre sa grille à un potentiel supérieur d'une tension de seuil, VT, au potentiel de sa source VS.

La présente invention propose d'atteindre ce résultat en réalisant un montage du type de celui illustré en figure 5.

La figure 5 représente un transistor VDMOS déplété 60 connecté à une diode zener 70. L'anode de la diode zener est reliée à la grille et au caisson du transistor VDMOS déplété et la cathode de la diode zener est reliée à la source du transistor déplété, le drain du transistor déplété 60 étant relié au drain du transistor VDMOS enrichi principal 1.

Ce mode de connexion est également illustré en figure 2, la connexion entre la grille et le substrat du transistor 60 étant désignée par la référence 82, la connexion entre le caisson du transistor VDMOS déplété et l'anode de la diode zener 70 étant réalisée par la métallisation 67-74, et la connexion entre la cathode de la diode zener et la source du transistor VDMOS déplété étant désignée par la référence 84.

Grâce à ce montage, on dispose aux bornes de la diode zener d'une tension VZ qui peut être appliquée par un interrupteur 90 (réalisé par un circuit logique de transistors MOS latéraux enrichis et déplétés formé sur la même puce) vers la grille du transistor VDMOS enrichi 1. L'anode de la diode zener est en outre reliée à une tension de référence VR qui peut être ou bien la source du transistor VDMOS enrichi ou bien la masse ou bien une autre tension choisie inférieure à VD. Ce montage permet d'appliquer, sans temps de retard, dès la fermeture de l'interrupteur 90 une tension de grille au transistor 1.

S'il est nécessaire de pouvoir fournir un courant important pour charger la grille du transistor VDMOS enrichi 1, on pourra rajouter à ce montage un couple Darlington de transistors bipolaires, la base du Darlington étant reliée à la source du transistor VDMOS déplété 60, le collecteur du Darlington étant relié aux drains des transistors VDMOS, et l'émetteur du Darlington étant relié à la borne de l'interrupteur 90 opposée à la grille du VDMOS enrichi 1.

Dans le cas où le circuit de puissance est du type "high side" comme représenté en figure 3, le transistor VDMOS enrichi étant initialement bloqué, la fermeture de l'interrupteur 90 permet d'appliquer la tension de 10 volts choisie sur la grille. Toutefois, tandis que le transistor VDMOS enrichi devient conducteur, le potentiel de sa source, VS, devient sensiblement égal à celui de son drain, VD, et il faudra de façon classique adjoindre au circuit de la figure 5 un circuit de pompe de charge pour fournir une tension plus élevée que VD d'environ 10 volts.

Avec un montage "low side" du type de la figure 4, une tension est disponible sur le drain du transistor VDMOS enrichi quand celui-ci est à l'état bloqué. Toutefois, quand le transistor 1 est conducteur, la chute de tension à ses bornes devient inférieure à VZ et il n'y a donc plus de tension disponible au niveau de l'interrupteur 90. Le circuit selon la présente invention pourra néanmoins être utilisé avec un condensateur en parallèle sur la diode zener 70 pour maintenir la tension de commande pendant les phases de conduction du transistor VDMOS enrichi dans le cas usuel où le transistor de puissance est commandé en commutation avec de brèves périodes successives de conduction et de blocage.

L'homme de l'art pourra apporter diverses variantes aux structures et circuits selon la présente invention. Par exemple, dans un souci de miniaturisation, la région de type P 71 d'anode de la diode zener pourra être formée dans un prolongement de la région 61 correspondant au caisson du transistor déplété 60.

## Revendications

1. Procédé de fabrication d'un circuit intégré comprenant des éléments de puissance du type transistor MOS vertical (VDMOS) enrichi (1) et des éléments logiques du type transistor MOS latéral déplété (2) et enrichi (3), dans un substrat épitaxié de type N/N⁺ (10,11), comprenant les étapes suivantes :
- une première étape de dopage de type P pour fournir notamment des zones correspondant à un caisson (12) dans lequel sont formés les transistors logiques,
- une deuxième étape de dopage de type P à dopage élevé permettant l'établissement de contacts ohmiques (17, 18),
- une troisième étape de dopage de type N pour former notamment les zones de canal (13) des transistors MOS déplétés,
- une quatrième étape de dopage de type P pour fournir notamment des zones (30) correspondant aux régions de canal du transistor VDMOS,
- une cinquième étape de dopage de type N à dopage élevé permettant l'établissement de contacts ohmiques (32-36),
- une seule étape de métallisation pour former par gravure diverses régions métallisées sur la face avant,
caractérisé en ce qu'il comprend en outre la fabrication d'un transistor VDMOS à canal N de type déplété (60) de drain commun avec le transistor VDMOS enrichi (1), comprenant une région de canal de type N (62) résultant de la troisième étape de dopage, un caisson P (61) résultant de la première étape de dopage et des régions de source N⁺ (64) formées dans lesdits caissons, résultant de la cinquième étape de dopage.

2. Procédé selon la revendication 1, caractérisé en ce qu'il comprend en outre la fabrication d'une diode zener (70) comprenant une région N⁺ (72) résultant de la cinquième étape de dopage formée dans une région P (71) résultant de la quatrième étape de dopage.

3. Procédé selon la revendication 2, caractérisé en ce que la région P de la diode zener est formée dans la couche épitaxiée de type N du substrat.

4. Procédé selon la revendication 2, caractérisé en ce que la région P de la diode zener est formée dans une région résultant de la deuxième étape de dopage et se prolongeant pour former un caisson du transistor VDMOS déplété.

5. Circuit intégré comprenant des éléments de puissance du type transistor MOS vertical (VDMOS) enrichi (1) formés dans une tranche de silicium épitaxiée N/N⁺, et des éléments logiques du type transistor MOS latéral déplété (2) et enrichi (3), formés dans un caisson P de la couche épitaxiée, caractérisé en ce qu'il comprend en outre une référence de tension interne résultant de la connexion en série d'un transistor VDMOS déplété (60) à drain commun avec le VDMOS enrichi et d'une diode zener (70) formée dans un caisson P de la couche épitaxiée dont la cathode est reliée à la source du transistor VDMOS déplété et dont l'anode est reliée au substrat et à la grille de ce transistor VDMOS déplété.

## Claims

1. A method for manufacturing an integrated circuit including power elements of the enhanced vertical MOS (VDMOS) transistor type (1) and logic elements comprising lateral depleted (2) and enhanced (3) MOS transistors, in an N/N⁺ epitaxial substrate (10, 11), comprising the following steps:
- a first P-type doping step, for supplying areas corresponding to a well (12) wherein are formed logic transistors,
- a second P-type doping step with high doping level permitting to establish ohmic contacts (17, 18),
- a third N-type doping step for forming channel regions (13) of the depleted MOS transistors,
- a fourth P-type doping step for forming regions (30) corresponding to channel regions of the VDMOS transistor,
- a fifth N-type doping step with a high doping level permitting to form ohmic contacts (32-36),
- a single metallization step for forming through etching various metallization regions on the front surface,
characterized in that it further comprises the manufacturing of a depleted N-channel VDMOS transistor (60) having a common drain with the enhanced VDMOS transistor (1), comprising an N-type channel region (62) resulting from the third doping step, a P well (61) resulting from the first doping step and N⁺ source regions (64, 65) resulting from the fifth doping step.

2. A method according to claim 1, characterized in that it further comprises the manufacturing of a zener diode (70) comprising an N⁺ region (72) resulting from the fifth doping step and formed in a P region (71) resulting from the fourth doping step.

3. A method according to claim 2, characterized in that the P region of the zener diode is formed in the N-type epitaxial layer of the substrate.

4. A method according to claim 2, characterized in that the P region of the zener diode is formed in a region resulting from the second doping step and extending to form a well for the depleted VDMOS transistor.

5. An integrated circuit including power elements of the vertical enhanced MOS (VDMOS) transistor type (1) formed in an epitaxial N/N⁺ silicon wafer and logic elements of the depleted (2) and enhanced (3) lateral MOS transistor type formed in a P well of the epitaxial layer, characterized in that it further comprises an internal voltage reference resulting from the series connection of a depleted VDMOS transistor (60) having a common drain with the enhanced VDMOS transistor and a zener diode (70), the cathode of which is connected to the source of the depleted VDMOS transistor and the anode is connected to the substrate and to the gate of said depleted VDMOS transistor.

## Patentansprüche

1. Verfahren zum Herstellen eines integrierten Schaltkreises mit Leistungskomponenten aus MOS-Vertikaltransistoren (VDMOS) vom Anreicherungstyp (1) und Logikkomponenten aus MOS-Flächentransistoren vom Verarmungstyp (2) und Anreicherungstyp (3), in einem Epitaxiesubstrat vom Typ N/N⁺ (10, 11) mit folgenden Schritten:
einem ersten P-Typ-Dotierungsschritt, um Zonen entsprechend einem Graben (12) zu bilden, in dem die logischen Transistoren ausgebildet werden,
einem zweiten P-Typ-Dotierungsschritt mit erhöhter Dotierung, der die Einrichtung von ohmschen Kontakten (17, 18) erlaubt,
einem dritten N-Typ-Dotierungsschritt, um die Kanalzonen (13) der MOS-Transistoren vom Verarmungstyp auszubilden,
einem vierten P-Typ-Dotierungsschritt, um Zonen (30) entsprechend Kanalzonen des VDMOS-Transistor auszubilden,
einem fünften N-Typ-Dotierungsschritt mit erhöhter Dotierung, der die Ausbildung von ohmschen Kontakten (32 - 36) erlaubt,
einem einzelnen Metallisierungsschritt, um durch Ätzen verschiedene metallisierte Bereiche auf der Oberfläche auszubilden,
dadurch gekennzeichnet, daß das Verfahren darüberhinaus die Herstellung eines VDMOS-Transistors mit einem N-Kanal vom Verarmungstyp (60) mit einer mit dem VDMOS-Transistor vom Anreicherungstyp (1) gemeinsamen Drain umfaßt, der einen Bereich eines N-Kanales (62) aufweist, der aus dem dritten Dotierungsschritt resultiert , einen P-Graben (61), der aus dem ersten Dotierungsschritt resultiert und Bereiche einer N⁺-Source (64), die in den genannten Gräben ausgebildet werden und aus dem fünften Dotierungsschritt resultiert.

2. Verfahren nach Anspruch 1, dadurch gekennzeichnet, daß es darüberhinaus die Herstellung einer Zenerdiode (70) umfaßt, die einen N⁺-Bereich (72) aufweist, der aus dem fünften Dotierungsschritt resultiert und in einem P-Bereich (71) gebildet wird, der aus dem vierten Dotierungsschritt resultiert.

3. Verfahren nach Anspruch 2, dadurch gekennzeichnet, daß der P-Bereich der Zenerdiode in der N-Epitaxieschicht des Substrates ausgebildet wird.

4. Verfahren nach Anspruch 2, dadurch gekennzeichnet, daß der P-Bereich der Zenerdiode in einem Bereich ausgebildet wird, der aus dem zweiten Dotierungsschritt resultiert und verlängert wird, um einen Graben des VDMOS-Transistors vom Verarmungstyp auszubilden.

5. Integrierter Schaltkreis mit Leistungskomponenten aus MOS-Vertikaltransistoren (VDMOS) vom Anreicherungstyp (1), die in einer Epitaxiescheibe aus N/N⁺-Silicium ausgebildet sind, und mit Logikkomponenten aus MOS-Flächentransistoren vom Verarmungstyp (2) und Anreicherungstyp (3), die in einem P-Graben der Epitaxieschicht ausgebildet sind, dadurch gekennzeichnet, daß er darüberhinaus eine interne Referenzspannung aufweist, die aus einer Serienschaltung eines VDMOS-Transistors vom Verarmungstyp (60) mit einer mit dem VDMOS-Transistor vom Anreicherungstyp gemeinsamen Drain und einer Zenerdiode (70) ausgebildet ist, die in einem P-Graben der Epitaxieschicht ausgebildet ist, deren Kathode mit der Source des VDMOS-Transistors vom Verarmungstyp verbunden ist und deren Anode mit dem Substrat und dem Gate dieses VDMOS-Transistors vom Verarmungstyp verbunden ist.
